# EUROPEAN PATENT APPLICATION

(11) **EP 3 855 514 A1**
(43) Date of publication of application: **28.07.2021**
(21) Application number: 19863570.8
(22) Date of filing: 02.09.2019
(51) Int. Cl.: H01L 33/48, H01L 23/02, H01L 31/02

(54) **LID FOR OPTICAL ELEMENT PACKAGE, OPTICAL ELEMENT PACKAGE, AND MANUFACTURING METHOD FOR LID FOR OPTICAL ELEMENT PACKAGE AND OPTICAL ELEMENT PACKAGE**

(30) Priority: 20.09.2018 JP 2018175824
(71) Applicant: SHIN-ETSU CHEMICAL CO., LTD., Tokyo 100-0004 (JP)
(72) Inventor: MATSUI Harunobu, Joetsu-shi, Niigata 942-8601 (JP); HARADA Daijitsu, Joetsu-shi, Niigata 942-8601 (JP); TAKEUCHI Masaki, Joetsu-shi, Niigata 942-8601 (JP)
(74) Representative: Mewburn Ellis LLP
(86) International application number: PCT/JP2019/034358
(87) International publication number: WO 2020/059468

(57) **Abstract**

A lid for an optical element package, comprising: a window material provided in front of the light emitting direction of an optical element of a housing member, inside which the optical element is housed; and a metal-based adhesive layer formed on a part at which the window material contacts the housing member, wherein with the lid for an optical element package, the metal-based adhesive layer is formed by an adhesive composition including metal nanoparticles, a solder powder, and a dispersion medium coated by a coating agent. It is possible to address deterioration and cracking due to light of short wavelengths, distortion or decay of the adhesive agent due to heat generation of the light emitting element, and the problem of long-term reliability accompanying these. Specifically, it is possible to provide the lid for an optical element package and the optical element package with excellent heat resistance, ultraviolet resistance, etc.

## Description

### TECHNICAL FIELD

The present invention relates to an optical element package lid that can be used in packages for optical elements, such as UV-LEDs and short-wavelength, high-power laser sources, particularly optical elements that emit or receive light in the ultraviolet region. The invention also relates to such an optical element package, and to methods for manufacturing the optical element package lid and the optical element package.

### BACKGROUND ART

When packaging an LED, it is necessary to use a window made of a material having high transmission to light emitted by the optical element. Translucent resins such as epoxy resins, silicone resins, modified acrylic resins and unsaturated polyesters have hitherto been used as window materials for LEDs (Patent Document 1: JP-A 2001-196644).

In recent years, given the restrictions that have been placed on mercury-vapor lamps, UV-LEDs that emit light having a short wavelength, particularly in the ultraviolet region, are attracting attention as an alternative. Because LEDs can extract light of any wavelength, LEDs with wavelengths adapted to the desired application are being developed. For example, UV-LEDs that emit 265 nm wavelength light in the UV region, which is a wavelength effective for disinfection, are being developed for disinfecting applications. However, even assuming a stable supply of 265 nm optical elements, the optical elements are difficult to use without packaging. Hence, there exists a need for packaging that maximizes the light extraction efficiency from UV-LEDs.

To this end, in the case of UV-LEDs, borosilicate glass or quartz glass is generally used as the window material for packages (Patent Document 2: JP-A 2006-269678). However, when a translucent resin or borosilicate glass is used as the window material, machining is easy, but low ultraviolet transmission is a drawback. On the other hand, when quartz glass is used as the window material, the ultraviolet transmission is excellent, but owing to its high softening point, quartz glass has a poor workability. Also, with both these materials, mirror finishing of the surface is effective for increasing the light extraction efficiency. However, with mirror finishing, light from an optical element having a high light directionality is not scattered by the window material, so that a member such as a diffuser filter for scattering the light is separately required to scatter light.

In addition, optical elements such as UV-LEDs are housed in housing members made of ceramics or the like, and they are required to be hermetically sealed with a window material through an adhesion layer. However, because the short-wavelength light emitted by UV-LEDs causes resin-based adhesives such as epoxy resins and silicone resins to deteriorate, this makes hermetic sealing impossible. A method which uses a laser to join a housing member and a window material has been disclosed to address this (Patent Document 3: JP-A 2017-191805).

### PRIOR ART DOCUMENTS

### PATENT DOCUMENTS

Patent Document 1: JP-A 2001-196644
Patent Document 2: JP-A 2006-269678
Patent Document 3: JP-A 2017-191805

### SUMMARY OF THE INVENTION

### TECHNICAL PROBLEM

The present invention was arrived at in the light of the above circumstances. An object of the invention is to provide, as a window material for an optical element package, an optical element package lid which has a high light transmission and, when used to seal a light-emitting element that generates a large amount of heat, such as an existing high-output LED, a UV-LED which emits UV light, a light-receiving element for UV light or the like, can be stably used for a long period of time without being affected by heat or short-wavelength light. Further objects are to provide such an optical element package, and methods for manufacturing the optical element package lid and the optical element package.

### SOLUTION TO THE PROBLEM

As a result of extensive investigations, the inventors have discovered that an optical element package which does not readily incur damage due to heat or short-wavelength light associated with the optical element and thus has long-term stability can be constructed using an optical element package lid having, on a housing member-adjoining portion of a window material provided forward of a housing member in a direction of light emission by an optical element housed within the housing member, a metallic adhesion layer formed of an adhesive composition containing metal nanoparticles coated with a coating agent, a solder powder and a dispersion medium. This discovery ultimately led to the present invention.

Accordingly, this invention provides the following optical element package lid, optical element package, and methods of manufacturing the optical element package lid and the optical element package.
1. A lid for an optical element package, which lid includes a window material provided in front of a housing member in a direction of light emission by an optical element housed inside the housing member, and a metallic adhesion layer formed on a portion of the window material that adjoins the housing member, wherein the metallic adhesion layer is formed of an adhesive composition which includes metal nanoparticles coated with a coating agent, a solder powder and a dispersion medium.
2. The optical element package lid of 1 above , wherein the metal making up the metal nanoparticles is one or more metal selected from the group consisting of gold, silver and copper, an alloy containing the metal, or a mixture of the metal with another metal.
3. The optical element package lid of 1 or 2 above, wherein the metal nanoparticles have an average primary particle size, as determined by dynamic light scattering, of from 20 to 90 nm.
4. The optical element package lid of any of 1 to 3 above, wherein the coating agent has a temperature of separation from the metal nanoparticles which is at or above a sintering temperature of the metal nanoparticles.
5. The optical element package lid of 4 above, wherein the coating agent includes one or more compound selected from the group consisting of amines, aliphatic carboxylic acids and alcohols.
6. The optical element package lid of 4 above, wherein the coating agent includes polyethylene glycol.
7. The optical element package lid of any of 1 to 6 above, wherein the metal nanoparticles have a sintering temperature of between 110°C and 180°C.
8. The optical element package lid of any of 1 to 7 above, wherein the solder powder has a melting point which is lower than the sintering temperature of the metal nanoparticles.
9. The optical element package lid of 8 above, wherein the solder powder includes at least one selected from the group consisting of Sn-Bi solder, Sn-Zn-Bi solder and Sn-Zn solder.
10. The optical element package lid of any of 1 to 9 above, wherein the dispersion medium has a volatilization onset temperature which is higher than the sintering temperature of the metal nanoparticles and higher than a melting point of the solder powder.
11. The optical element package lid of 10 above, wherein the dispersion medium includes one or more compound selected from the group consisting of terpenes, monoterpene alcohols, alkyl alcohols and naphthenic hydrocarbons.
12. The optical element package lid of any of 1 to 11 above, wherein the metallic adhesion layer is in a semi-cured state (B-Stage).
13. A method for manufacturing the optical element package lid of any of 1 to 12 above, which method includes the step of:
   forming the metallic adhesion layer by applying the adhesive composition onto a portion of the window material that adjoins the housing member.
14. An optical element package which includes an optical element and a housing member that houses therein the optical element, wherein the metallic adhesion layer of the optical element package lid of any of 1 to 12 above bonds together the window material and the housing member, hermetically sealing the optical element inside the housing member.
15. The optical element package of 14 above, wherein the optical element is a light-emitting element or a light-receiving element.
16. The optical element package of 15 above, wherein the optical element is an optical element capable of emitting or receiving light at a wavelength of 300 nm or less.
17. A method for manufacturing the optical element package of any of 14 to 16 above, which method includes the steps of:
   mounting an optical device inside a housing member, and
   bonding and integrally uniting, by means of the metallic adhesion layer of the optical element package lid, the window material of the optical element package lid of any one of 1 to 12 above with the housing member that houses therein the optical device.

### ADVANTAGEOUS EFFECTS OF THE INVENTION

This invention, by addressing deterioration and cracking due to short-wavelength light and adhesive strain and breakdown due to heat generation by a light-emitting element, is able to resolve the problem of long-term reliability associated therewith. That is, the invention enables an optical element package lid and an optical element package of excellent heat resistance and ultraviolet resistance to be provided.

### BRIEF DESCRIPTION OF THE DRAWINGS

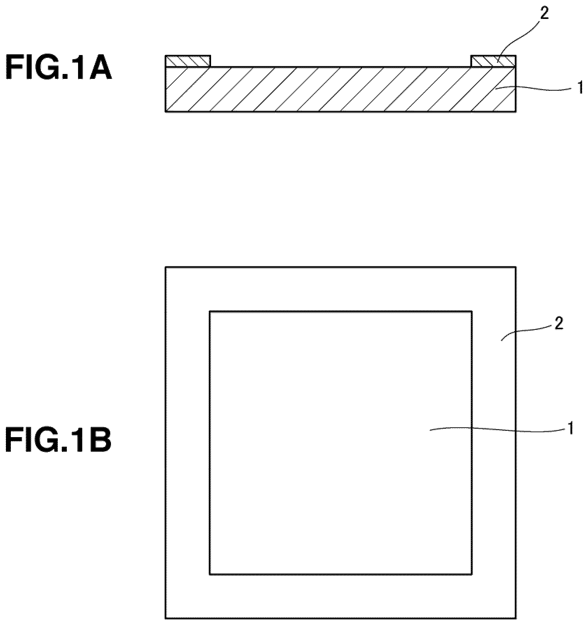

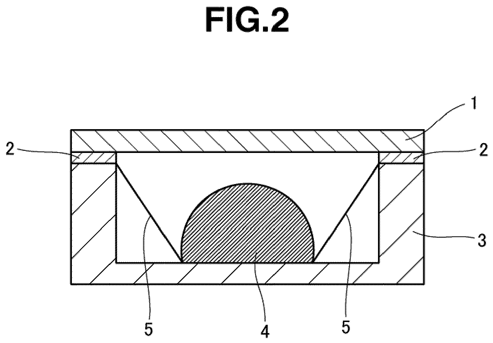

FIG. 1 shows an embodiment of an optical device package lid according to the invention, FIG. 1A being a cross-sectional view of the lid and FIG. 1B being a plan view of the lid. FIG. 2 is a cross-sectional diagram showing an example of an optical element package which uses an optical device package lid according to the invention to house an optical element in a housing member.

### DESCRIPTION OF EMBODIMENTS

The invention is described in detail below.

The optical element package lid of the invention has a window material that is provided in front of a housing member in a direction of light emission by an optical element housed inside the housing member, and a metallic adhesion layer formed on a portion of the window material that adjoins the housing member. The optical element package lid, which is used together with a housing member that houses an optical element, is employed both to protect the optical element and also to facilitate handling of the optical element.

As shown in, for example, the cross-sectional and plan views in, respectively, FIGS. 1A and 1B, the optical element package lid has a metallic adhesion layer 2 that is formed on a surface of a window material 1, such as an outer peripheral edge of a principal surface of the window material 1 where it adjoins the housing member. Aside from the principal surfaces of the window material, this metallic adhesion layer may be formed on sidewalls, although it is preferably formed only on the principal surfaces, particularly only one principal surface adjoining the housing member which houses the optical element. Also, the metallic adhesion layer is preferably formed on the outer peripheral edge of the principal surface of the window material such that, as shown in FIGS. 1A and 1B, light can be extracted from the central portion of the window material, although it is not always necessary for the metallic adhesion layer to be formed up to the outer peripheral edge of the window material. In addition, the metallic adhesion layer should be formed at a position that ensures a suitable range where light can be extracted at the central portion of the window material, and with a shape and surface area sufficient for hermetic sealing.

The window material may be any from among, for example, synthetic quartz glass, sapphire, borosilicate glass and alkali-free glass. However, from the standpoint of such properties as the light transmission, heat resistance and UV resistance, synthetic quartz glass is preferred.

The window material has a shape which, aside from the flat shape of the window material 1 shown in FIG. 1A, may be spherical with a concavo-convex shape (here and below, this includes concave shapes, convex shapes, and shapes that are both concave and convex) or non-spherical with a concavo-convex shape. When the purpose is simply to seal the housing member that houses the optical element, from the standpoint of cost and ease of handling, a flat plate-like window material is preferred. On the other hand, in cases where the aim is to efficiently extract the light that is emitted by the optical element, a spherical or non-spherical window material having a concavo-convex shape designed based on optical calculations, such as a simple planoconvex lens shape, planoconcave lens shape, convex meniscus lens shape or the like, is preferred. The thickness of the window material may be suitably selected. However, from the standpoint of stresses and the like that arise during bonding, the thickness is preferably at least 0.1 mm, and more preferably at least 0.2 mm, and is preferably not more than 5 mm, and more preferably not more than 4 mm.

The window material is preferably one which can hermetically seal the interior of the housing member. The size thereof is suitably selected according to, for example, the intended use of the optical element, the optical element that is housed and the size of the housing member. However, from the standpoint of ensuring hermeticity, use can be made of a window material having a size that is the same as or somewhat larger than the size of the opening in the optical element housing portion of the housing member. The length of the diagonals in cases where the horizontal shape is square, and the diameter or largest dimension in cases where the horizontal shape is, respectively, circular or elliptical, is preferably at least 1 mm, and more preferably at least 2 mm, and is preferably not more than 3 cm, and more preferably not more than 2 cm.

Also, from the standpoint of the light extraction efficiency, preferably at least one side (i.e. the front side only or the back side only) of the opposing substrate sides (principal surfaces) is a mirror surface, and more preferably both the front side and the back side are mirror surfaces. Here, the two opposing sides of the substrate, i.e. the front side and the back side, can be made, for example, two sides where light crosses when light emitted from the optical element or light received by the optical element passes through the window material. The mirror surface can be prepared as a surface having an arithmetic mean roughness (Ra) of preferably 0.1 µm or less, and more preferably 0.05 µm or less.

The method of producing the window material is not particularly limited. For example, a flat window material can be produced by lapping, and a spherical window material having a concavo-convex shape or a non-spherical window material having a concavo-convex shape can be produced by sandblasting, one side selected from the front and back sides, or both sides, of a starting substrate. A flat substrate, such as a flat substrate having a thickness of from 0.2 to 10 mm that is rectangular with diagonal lengths of from 100 to 300 mm or circular with a diameter of from 100 to 300 mm, may be suitably used as the starting substrate. In the case of lapping, polishing is carried out on one or both sides with a single-side polishing machine or a double-side polishing machine using, for example, abrasive grains (abrasive) composed primarily of alumina. On the other hand, in the case of sandblasting, polishing is carried out using an abrasive such as cerium oxide, silicon oxide, aluminum oxide or silicon carbide. In addition, when a mirror surface is to be formed, after lapping or sandblasting, in the case of a flat window material, polishing may be carried out by single-side polishing or double-side polishing using a known abrasive in which abrasive grains such as cerium oxide or zirconium oxide are combined with an expanded polyurethane abrasive cloth; in the case of a spherical window material having a concavo-convex shape or a non-spherical window material having a concavo-convex shape, mirror finishing may be carried out by a known etching treatment with aqueous hydrofluoric acid or the like.

The metallic adhesion layer is formed using an adhesive composition containing metal nanoparticles coated with a coating agent, a solder powder and a dispersion medium.

### Metal Nanoparticles Coated with Coating Agent

The metal nanoparticles included in the metallic adhesion layer are very small particles and so, unless they are coated with a substance that can prevent primary particles from mutually coupling, coupling will occur due to the inherent sinterability of metal nanoparticles and it will be impossible to maintain the primary particles in a dispersed state. Hence, the metal nanoparticles are used in a state where the particle surfaces have been coated with a coating agent (e.g. a state where a liquid substance or solid substance has been deposited on the surface).

The metal making up the metal nanoparticles is preferably one or more metal selected from the group consisting of gold, silver and copper, an alloy containing this metal, or a mixture of this metal with another metal. When it is an alloy or a mixture, one or more metal selected from the group consisting of gold, silver and copper accounts for preferably at least 80 wt% of the overall metal nanoparticles.

Primary particles of the metal nanoparticles have an average particle size (average primary particle size) Dso (volume median diameter) which, from the standpoint of increasing the number of reaction sites between the metal nanoparticles and the solder powder or from the standpoint of facilitating handling, is preferably at least 20 nm, and more preferably at least 30 nm, and is preferably not more than 90 nm, and more preferably not more than 80 nm. The value measured by dynamic light scattering can be employed as this particle size.

The coating agent, from the standpoint of achieving a bond at low temperature (e.g. between 150°C and 330°C) in bonding of the window material with the housing member by the metallic adhesion layer, is preferably one that has temperature responsiveness and separates from the metal nanoparticle surfaces. The temperature at which the coating agent separates from the metal nanoparticles (separation temperature) is preferably a temperature of at or above the sintering temperature of the metal nanoparticles, more preferably a temperature of at least 10°C higher than the sintering temperature of the metal nanoparticles, and even more preferably a temperature of at least 25°C higher than the sintering temperature of the metal nanoparticles. On the other hand, the separation temperature of the coating agent is preferably not more than a temperature higher than the sintering temperature of the metal nanoparticles by 50°C ((sintering temperature of metal nanoparticles + 50°C) or less). The temperature at which the coating agent separates from the metal nanoparticles (separation temperature) may be set to the temperature at which the metal nanoparticles begin mutually necking. As used herein, "necking" of the metal nanoparticles refers to mutual bonding of the metal nanoparticles due to separation of the coating agent from the metal nanoparticle surfaces. When necking occurs, there arises a weight change accompanying loss of the coating agent from the metal nanoparticle surfaces. By determining this weight change from TG-DTA (thermogravimetric/differential thermal analysis) measurement, the temperature at which weight change begins to arise on the TG curve obtained by TG-DTA measurement can be treated as the separation temperature. An example of suitable conditions for TG-DTA measurement is measurement while heating a 10 mg specimen from 50°C at a rate of temperature rise of 5°C per minute. The sintering temperature for the metal nanoparticles is subsequently described.

The coating agent is preferably one having a boiling point of at least 100°C and not more than 300°C. The boiling point of the coating agent is more preferably at least 120°C and is more preferably not more than 200°C. The coating agent preferably includes at least one compound selected from the group consisting of amines, aliphatic carboxylic acids and alcohols. Specific examples include amines having from 6 to 12 carbon atoms, such as hexylamine, cyclohexylamine and octylamine; aliphatic carboxylic acids (saturated fatty acids) having from 6 to 16 carbon atoms, such as hexanoic acid, octanoic acid, decanoic acid, dodecanoic acid and hexadecanoic acid; and alcohols having from 6 to 12 carbon atoms, such as 1-hexanol, 1-octanol, 1-decanol and 1-dodecanol. Alternatively, the coating agent may be a polymeric compound, such as a polyethylene glycol preferably having a weight-average molecular weight of from 200 to 500 (preferably one having a polydispersity of from 1.00 to 1.50). It is effective to use two or more types of coating agents so that they separate from the metal nanoparticle surfaces at different times and the metal nanoparticles do not explosively sinter with each other, and so as to increase the rate of conversion when the metal nanoparticles react with the solder powder to form an alloy.

In bonding of the window material with the housing member by the metallic adhesion layer, it is essential that the metal nanoparticles following separation of the coating agent react with each other or with the solder powder. In this case, from the standpoint of achieving a bond at low temperature (e.g. between 150°C and 300°C), the metal nanoparticle sintering temperature is preferably at least 110°C, and is preferably not more than 180°C, and more preferably not more than 160°C. Here, the sintering temperature of the metal nanoparticles may be regarded as the temperature at which the metal nanoparticles become unable to maintain their shape as primary particles.

The content of metal nanoparticles coated with a coating agent in the adhesive composition is preferably at least 20 wt%, and more preferably at least 25 wt%, and is preferably not more than 70 wt%, and more preferably not more than 50 wt%. In this case, the proportion of metal nanoparticles relative to the sum of the coating agent and the metal nanoparticles is preferably at least 80 wt%, and more preferably at least 85 wt%, and is less than 100 wt%, preferably 98 wt% or less, and more preferably 95 wt% or less.

### [Solder Powder]

In the case of a metallic adhesion layer which uses only metal nanoparticles as the metal material, during bonding, even though the distance between metal nanoparticles is reduced by the application of pressure, the resulting adhesion layer becomes a structure having voids and so is not an adhesion layer that imparts sufficient hermeticity. In this invention, to enable the resulting adhesion layer to impart sufficient hermeticity, that is, in order to fill the foregoing voids, a solder powder is included in the adhesive composition as a material which has flowability during bonding and also is preferably capable of forming an alloy with the metal nanoparticles.

The solder powder has a melting point which, from the standpoint of achieving a bond at low temperature (e.g. between 150°C and 330°C) in adhesion of the window material with the housing member by means of the metallic adhesion layer, is preferably a lower temperature than the sintering temperature of the metal nanoparticles. Such a melting point is preferably 180°C or less, more preferably 170°C or less, and even more preferably 160°C or less. The lower limit in the melting point of the solder powder is generally at least 100°C. In order to achieve this temperature range, it is preferable to include tin as a solder constituent. In addition, when synthetic quartz glass is used as the window material, to obtain a reliable adherence therewith, it is more preferable to include bismuth, which has a good wettability to synthetic quartz glass. One or more selected from the group consisting of Sn-Bi solder, Sn-Zn-Bi solder and Sn-Zn solder is preferably included as such a solder powder.

The average particle size of primary particles (average primary particle size) Dso (volume median diameter) of the solder powder, from the standpoint of preventing sintering between metal nanoparticles prior to bonding, and also from the standpoint of having the solder powder react efficiently with the metal nanoparticles during bonding, is preferably from 1 to 100 µm, and more preferably from 1 to 50 µm. Also, the content of solder powder in the adhesive composition is preferably at least 30 wt%, and more preferably at least 45 wt%, and is preferably not more than 80 wt%, and more preferably not more than 70 wt%.

### Dispersion Medium

In the adhesive composition making up the metallic adhesion layer, metal nanoparticles whose surfaces are exposed due to separation of the coating agent react with the solder powder to form an alloy, by means of which bonding between the window material and the housing member takes place. It is effective for this reaction to proceed with the metal nanoparticles and the solder powder in a flowing state, that is, for the reaction to proceed in the presence of a dispersion medium that is a liquid. From this standpoint, a liquid dispersion medium is included in the adhesive composition.

The dispersion medium has a volatilization onset temperature which, from the standpoint of bringing the reaction between the metal nanoparticles and the solder powder to completion in a liquid phase, is higher than the sintering temperature of the metal nanoparticles. Also, from the same standpoint, the volatilization onset temperature of the dispersion medium is preferably higher than the melting point of the solder powder, and more preferably a temperature of at least 10°C higher than the melting point of the solder powder, and is preferably not more than a temperature higher than the melting point of the solder powder by 50°C (melting point of solder powder + 50°C) or less), and more preferably not more than a temperature higher than the melting point of the solder powder by 30°C (melting point of solder powder + 30°C) or less). Here, the volatilization onset temperature of the dispersion medium can be treated as the temperature at which vaporization begins when the dispersion medium incurs heating from 25°C under a pressure of 1 atmosphere.

The dispersion medium preferably includes at least one compound selected from the group consisting of terpenes, monoterpene alcohols, alkyl alcohols and naphthenic hydrocarbons. Specific examples of terpenes include prenol, limonene and 3-methylbutanoic acid. Terusolve THA-90 and Terusolve THA-70 (both products of Nippon Terpene Chemicals, Inc.) are preferred. Specific examples of monoterpene alcohols include terpineol and dihydroterpineol. Preferred examples of alkyl alcohols include alkyl alcohols having at least six carbon atoms, preferably at least 8 carbon atoms, and preferably not more than 12 carbon atoms, such as 1-hexanol, 1-octanol, 1-decanol and lauryl alcohol. Linear (straight-chain) alkyl alcohols are more preferred. Specific examples of naphthenic hydrocarbons include cyclopentane and cyclohexane.

The content of dispersion medium in the adhesive composition is preferably at least 3 wt%, and more preferably at least 5 wt%, but preferably not more than 15 wt%, and more preferably not more than 12 wt%. The adhesive composition preferably includes the metal nanoparticles coated with a coating agent, the solder powder and the dispersion medium in a combined amount of at least 99 wt%, and more preferably is substantially composed solely of the metal nanoparticles coated with a coating agent, the solder powder and the dispersion medium.

The dispersion medium volatilizes in the step of bonding the window material and the housing member by means of the metallic adhesion layer. To elicit a firm bonding strength in the bonded state between the window material and the housing member, it is effective to adjust the properties of the ingredients included in the adhesive composition, or to adjust the amounts thereof according to the bonding conditions, in such a way that, once the window material and the housing member are in a bonded state by means the metallic adhesion layer, substantially all of the dispersion has volatilized.

Taking into consideration the heat resistance of the optical element housed in the housing member, it is preferable for the metallic adhesion layer to be one which can bond at a low temperature (e.g. between 150°C and 330°C) under loading of from 50 to 500 gf/package (from 0.49 to 4.9 N/package). Also, the metallic adhesion layer may be one which, to a degree where the adhesive composition does not flow out, has been placed in a semi-cured state (B-Stage).

The metallic adhesion layer has a thickness which, from the standpoint of making the thickness capable of absorbing shapes such as undulations should they exist at the junction between the housing member and the window material, is preferably at least 20 µm, and more preferably at least 30 µm, but is preferably not more than 70 µm, and more preferably not more than 50 µm. The thickness can be measured with a laser surface displacement gauge (e.g. KS-1100 from Keyence Corporation).

The optical element package lid of the invention can be manufactured by a method that includes the step of forming a metallic adhesion layer by applying an adhesive composition onto a portion of the window material that adjoins the housing member. In cases where the metallic adhesion layer is to be rendered into a semi-cured state (B-Stage), the metallic adhesion layer formed by applying the adhesive composition can be placed in a semi-cured state (B-Stage) by preferably 5 to 60 minutes of heating at preferably between 100°C and 180°C.

By using such an optical element package lid, it is possible to construct an optical element package having an optical element and a housing member inside which is housed the optical element, wherein the window material and the housing member are bonded together by the metallic adhesion layer of the optical element package lid, hermetically sealing the optical element inside the housing member. Specifically, as shown in FIG. 2 for example, it is possible to construct an optical element package in which hermetic sealing by a metal seal via the metallic adhesion layer 2 has been achieved between a window material 1 and a housing member 3 within which an optical element 4 is housed. In FIG. 2, 5 denotes a reflector.

The housing member that is used may be one which is known as a member for housing optical elements in optical element packages. One having, as the optical element housing portion, a recessed portion that is formed of an inorganic material such as metal or ceramic, or an organic material such as rubber, elastomer or resin, may be used. The size is suitably selected according to, for example, the intended use of the optical element and the sizes of the optical element to be housed and the window material. Also, particularly in the case of UV-LEDs, those that are currently known release most of the light emitted by the optical element as heat rather than light, and so it is desirable for the housing member to be formed of an alumina-based ceramic, aluminum nitride-based ceramic or the like which has good heat-dissipating properties, or of any of these which has been additionally, for example, metal plated with gold, copper or the like.

The optical element disposed at the interior of the housing member may be a light-emitting element or a light-receiving element. The optical element package of the invention is particularly suitable for optical elements which are capable of emitting or receiving light having a wavelength of 300 nm or less. Specific examples of light-emitting elements include UV-LEDs (e.g. those which include light with a peak wavelength of from 250 to 290 nm and a wavelength of 300 nm or less), ArF excimer lasers (wavelength, 193 nm), KrF excimer lasers (wavelength, 248 nm), and YAG FHG (fourth harmonic generation) lasers (wavelength, 266 nm). Examples of light-receiving elements are photodiodes capable of detecting ultraviolet light.

Apart from the optical element, other members may also be provided in the area enclosed by the housing member and the window material, such as a lead for electrically connecting the optical element with the exterior of the optical element package or a reflector for increasing the light extraction efficiency. Those portions other than the optical element and such other members may be in a vacuum state, a state filled with a gas, such as air or an inert gas such as nitrogen, or in a state encapsulated with a solid encapsulant such as a transparent rubber, elastomer or resin. However, from the standpoint of, for example, the ability to dissipate heat generated by the optical element, a state that is not encapsulated with a solid encapsulant, such as a vacuum state or a state filled with a gas, such as air or an inert gas such as nitrogen, is preferred.

The optical element package of the invention can be manufactured by a method that includes the steps of mounting an optical device inside a housing member; and bonding and integrally uniting, by means of the metallic adhesion layer of the optical element package lid, the window material of the optical element package lid with the housing member that houses therein the optical device.

The optical element package lid on which is formed the metallic adhesion layer brings the metallic adhesion layer into contact with the housing member inside which is housed an optical element, and thus determines the bonding position, following which the optical element package lid and the housing member can be bonded together by heat treatment. The temperature of such heat treatment (curing temperature), from the standpoint of the heat resistance of the optical element sealed inside the optical element package, is preferably at least 150°C, and more preferably at least 170°C, and is preferably 330°C or less, more preferably 300°C or less, and even more preferably 280°C or less. The heat treatment time is preferably from 10 seconds to 60 minutes. It is preferable to carry out pressurization at the same time; the atmosphere in such treatment may be, for example, an open-air atmosphere, an inert gas atmosphere, or a nitrogen gas atmosphere. In the case of an optical element package lid in which the adhesive composition that forms the metallic adhesion layer in in a semi-cured state (B-Stage), the metallic adhesion layer flattens due to heating and the metal nanoparticles included in the adhesive composition densely bond with one another, enabling a highly hermetic seal to be created.

In addition, a heat aging step may be provided after the window material and the housing member within which is housed the optical element have been bonded and integrally united by the metallic adhesion layer of the optical element package lid. A heat aging step is desirable because bonding among the metal nanoparticles in the metallic adhesion layer and bonding between the metal nanoparticles and the solder powder becomes stronger, increasing the adhesive strength. The heat aging temperature is preferably a temperature of at least 20°C higher than the curing temperature (the temperature of the above heat treatment), and preferably not more than a temperature higher than the curing temperature by 100°C (curing temperature + 100°C or less). The upper limit in the heat aging temperature is not particularly limited, although from the standpoint of the heat resistance of the optical element sealed within the optical device package, it is preferably 350°C or less. The heat aging time, from the standpoint of heat build-up in the optical element and productivity, is preferably from 10 to 180 minutes.

### EXAMPLES

Examples and Comparative Examples are given below to more fully illustrate the invention, although the invention is not limited by these Examples.

### Example 1

An adhesive composition containing 25 wt% of silver nanoparticles having an average primary particle size Dso of 53 nm and coated on the surface with a coating agent that is a mixture of 1-hexanol and 1-octanol (1-hexanol : 1-octanol = 1:1 (weight ratio)) (proportion of silver nanoparticles with respect to sum of coating agent and silver nanoparticles, 90 wt%), 67 wt% of a Sn-Bi solder powder having an average primary particle size Dso of 3.1 µm (from Mitsui Mining & Smelting Co., Ltd.) and 8 wt% of lauryl alcohol as the dispersion medium was applied by screen printing in a 3.4 mm square window frame-like shape having a linewidth of 250 µm and a thickness of 35 µm onto one side of a synthetic quartz glass wafer substrate (4-inch diameter, 0.5 mm thickness) mirror-finished on both opposing substrate surfaces (principal surfaces), forming a metallic adhesion layer.

The synthetic quartz glass wafer substrate on which the adhesion layer had been formed was subsequently heated for 20 minutes at 140°C, thereby rendering the metallic adhesion layer into a semi-cured state. The synthetic quartz glass wafer substrate was then diced along the outer periphery of the 3.4 mm square window frame-shaped adhesion layer to give an optical element package lid (synthetic quartz glass lid) having a synthetic quartz glass window material and a metallic adhesion layer.

Next, using as the housing member a surface-mount device (SMD) package which is made of gold-plated aluminum nitride and has a recessed area that serves as the housing portion, a UV-LED that emits 265 nm light was placed as the optical element in the recessed area, the synthetic quartz glass lid obtained as described above was set on the housing member so as to cover the recessed area in which the UV-LED has been placed, and the window material and the housing member were bonded by applying heat and pressure for 3 minutes under conditions of 230°C and 200 gf/package (1.96 N/package), thereby giving an optical element package. The hermeticity of the resulting optical element package was evaluated by the following tests.

### Red Check

The optical element package was immersed 24 hours in Micro-Check Penetrating Fluid JIP 143 (Ichinen Chemicals Co., Ltd.), and then washed with acetone and examined under a microscope. This red check was performed before and after the subsequently described evaluation of resistance to ultraviolet light.

### Fine Leak Test

A fine leak test using helium was performed in accordance with U.S. MIL-STD-883 Test Method 1014. First, the optical element package was placed at rest in a vacuum for one hour, then it was placed at rest for 6 hours in a 0.3 MPa helium gas atmosphere, after which the helium leak rate was measured with a helium leak tester.

### Evaluation of Resistance to Ultraviolet Light

When the optical element was a UV-LED, the bonding state was examined and a red dye check was performed after the UV-LED within the optical device package had been lit for 5,000 hours. When the optical element was a photodiode, the bonding state was examined and a red dye check was performed after 5,000 hours of ultraviolet irradiation, from above the window material in the optical element package, with a UV-LED that emits 265 nm light.

In each of the red dye checks before and after the evaluation of resistance to ultraviolet light, no infiltration of the penetrating fluid into the optical element package was observed and the maintenance of sufficient hermeticity was confirmed. Also, the helium leak rate in the fine leak test was 5.4×10⁻⁹ Pa·m³/s, indicating sufficient hermeticity. In addition, in the evaluation of resistance to ultraviolet light, no separation was observed between the window material and the housing member; even with examination of the bonding joint by microscope, there were no cracks or the like in the region where the metallic adhesion layer was cured.

### Example 2

An adhesive composition containing 60 wt% of silver nanoparticles having an average primary particle size Dso of 78 nm and coated on the surface with a coating agent that is a mixture of 1-hexanol and hexylamine (1-hexanol : hexylamine = 1: 1 (weight ratio)) (proportion of silver nanoparticles with respect to sum of coating agent and silver nanoparticles, 83 wt%), 33 wt% of a Sn-Zn solder powder having an average primary particle size Dso of 3.9 µm (Sasaki Solder Industry Co., Ltd.) and 7 wt% of Terusolve THA-90 (Nippon Terpene Chemicals, Inc.) as the dispersion medium was applied by screen printing in a 3.4 mm square window frame-like shape having a linewidth of 350 µm and a thickness of 40 µm onto one side of a synthetic quartz glass wafer substrate (6-inch diameter, 0.3 mm thickness) mirror-finished on both opposing substrate surfaces (principal surfaces), forming a metallic adhesion layer.

The synthetic quartz glass wafer substrate on which the adhesion layer had been formed was heated for 45 minutes at 170°C, thereby rendering the metallic adhesion layer into a semi-cured state. The synthetic quartz glass wafer substrate was then diced along the outer periphery of the 3.4 mm square window frame-shaped adhesion layer to give an optical element package lid (synthetic quartz glass lid) having a synthetic quartz glass window material and a metallic adhesion layer.

Next, using as the housing member an SMD package which is made of gold-plated alumina and has a recessed area as the housing portion, a UV-LED that emits 280 nm light was placed as the optical element in the recessed area, the synthetic quartz glass lid obtained as described above was set on the housing member so as to cover the recessed area in which the UV-LED has been placed, and the window material and the housing member were bonded by applying heat and pressure for 2 minutes under conditions of 270°C and 50 gf/package (0.49 N/package), thereby giving an optical element package. The hermeticity of the resulting optical element package was evaluated in the same way as in Example 1.

In each red dye check before and after the evaluation of resistance to ultraviolet light, no infiltration of the penetrating fluid into the optical element package was observed and the maintenance of sufficient hermeticity was confirmed. Also, the helium leak rate in the fine leak test was 5.2× 10⁻⁹ Pa·m³/s, indicating sufficient hermeticity. In addition, in the evaluation of resistance to ultraviolet light, no separation was observed between the window material and the housing member; even with examination of the bonding joint by microscope, there were no cracks or the like in the region where the metallic adhesion layer was cured.

### Example 3

An adhesive composition containing 23 wt% of silver nanoparticles having an average primary particle size Dso of 32 nm and coated on the surface with a coating agent that is a mixture of hexanoic acid and decanoic acid (hexanoic acid : decanoic acid = 1: 1 (weight ratio)) (proportion of silver nanoparticles with respect to sum of coating agent and silver nanoparticles, 93 wt%), 67 wt% of a Sn-Bi solder powder having an average primary particle size Dso of 2.9 µm (Mitsui Mining & Smelting Co., Ltd.) and 10 wt% of Terusolve THA-70 (Nippon Terpene Chemicals, Inc.) as the dispersion medium was applied by screen printing in a 5.9 mm square window frame-like shape having a linewidth of 200 µm and a thickness of 30 µm onto one side of a sapphire substrate (3-inch diameter, 0.5 mm thickness) mirror-finished on both opposing substrate surfaces (principal surfaces), forming a metallic adhesion layer.

The sapphire substrate on which the adhesion layer had been formed was heated for 30 minutes at 120°C, thereby rendering the metallic adhesion layer into a semi-cured state. The sapphire substrate was then diced along the outer periphery of the 5.9 mm square window frame-shaped adhesion layer to give an optical element package lid (sapphire lid) having a sapphire window material and a metallic adhesion layer.

Next, using as the housing member an SMD package which is made of gold-plated aluminum nitride and has a recessed area as the housing portion, a photodiode that receives 200 to 300 nm light was placed as the optical element in the recessed area, the sapphire lid obtained as described above was set on the housing member so as to cover the recessed area in which the photodiode has been placed, and the window material and the housing member were bonded by applying heat and pressure for 30 seconds under conditions of 300°C and 300 gf/package (2.94 N/package), thereby giving an optical element package. The hermeticity of the resulting optical element package was evaluated in the same way as in Example 1.

In each red dye check before and after the evaluation of resistance to ultraviolet light, no infiltration of the penetrating fluid into the optical element package was observed and the maintenance of sufficient hermeticity was confirmed. Also, the helium leak rate in the fine leak test was 4.7×10⁻⁹ Pa·m³/s, indicating sufficient hermeticity. In addition, in the evaluation of resistance of ultraviolet light, no separation was observed between the window material and the housing member; even under examination of the bonding joint by microscope, there were no cracks or the like in the area where the metallic adhesion layer was cured.

### Example 4

An adhesive composition containing 22.5 wt% of silver nanoparticles A having an average primary particle size Dso of 45 nm and coated on the surface with a coating agent that is Polyethylene Glycol #400 having a polydispersity of 1.05 (Nacalai Tesque Inc.; average molecular weight, 380 to 420) (proportion of silver nanoparticles with respect to sum of coating agent and silver nanoparticles, 87 wt%), 7.5 wt% of silver nanoparticles B having an average primary particle size Dso of 53 nm and coated on the surface with the same coating agent (proportion of silver nanoparticles with respect to sum of coating agent and silver nanoparticles, 91 wt%) (silver nanoparticles A : silver nanoparticles B = 3:1 (weight ratio); combined amount, 30 wt%), 62 wt% of a Sn-Bi solder powder having an average primary particle size Dso of 2.2 µm (Mitsui Mining & Smelting Co., Ltd.) and 8 wt% of Terusolve THA-90 (Nippon Terpene Chemicals, Inc.) as the dispersion medium was applied by screen printing in a 3.4 mm square window frame-like shape having a linewidth of 280 µm and a thickness of 40 µm onto one side of a synthetic quartz glass wafer substrate (4-inch diameter, 0.25 mm thickness) mirror-finished on both opposing substrate surfaces (principal surfaces), forming a metallic adhesion layer.

The synthetic quartz glass wafer substrate on which the adhesion layer had been formed was heated for 20 minutes at 150°C, thereby rendering the metallic adhesion layer into a semi-cured state. The synthetic quartz glass wafer substrate was then diced along the outer periphery of the 3.4 mm square window frame-shaped adhesion layer to give an optical element package lid (synthetic quartz glass lid) having a synthetic quartz glass window material and a metallic adhesion layer.

Next, using as the housing member an SMD package which is made of gold-plated aluminum nitride and has a recessed area as the housing portion, a UV-LED that emits 285 nm light was placed as the optical element in the recessed area, the synthetic quartz glass lid obtained as described above was set on the housing member so as to cover the recessed area in which the UV-LED has been placed, and the window material and the housing member were bonded by applying heat and pressure for 2 minutes under conditions of 180°C and 200 gf/package (1.96 N/package), following which 10 minutes of heat aging at 250°C and in the absence of loading was carried out, thereby giving an optical element package. The hermeticity of the resulting optical element package was evaluated in the same way as in Example 1.

In each red dye check before and after the evaluation of resistance to ultraviolet light, no infiltration of the penetrating fluid into the optical element package was observed and the maintenance of sufficient hermeticity was confirmed. Also, the helium leak rate in the fine leak test was 5.0×10⁻⁹ Pa·m³/s, indicating sufficient hermeticity. In addition, in the evaluation of resistance of ultraviolet light, no separation was observed between the window material and the housing member; even with examination of the bonding joint by microscope, there were no cracks or the like in the region where the metallic adhesion layer was cured.

### Comparative Example 1

The thermosetting epoxy adhesive Elephan CS (Tomoegawa Co., Ltd.) was applied by screen printing in a 3.4 mm square window frame-like shape having a linewidth of 250 µm and an adhesion layer thickness of 35 µm onto one side of a synthetic quartz glass wafer substrate (4-inch diameter, 0.5 mm thickness) mirror-finished on both opposing substrate surfaces (principal surfaces), forming an adhesion layer composed of epoxy adhesive.

The synthetic quartz glass wafer substrate on which the adhesion layer had been formed was heated for 20 minutes at 100°C, thereby rendering the adhesion layer made of epoxy adhesive into a semi-cured state. The synthetic quartz glass wafer substrate was then diced along the outer periphery of the 3.4 mm square window frame-shaped adhesion layer to give an optical element package lid (synthetic quartz glass lid) having a synthetic quartz glass window material and an adhesion layer made of epoxy adhesive.

Next, using as the housing member an SMD package which is made of gold-plated aluminum nitride and has a recessed area as the housing portion, a UV-LED that emits 265 nm light was placed as the optical element in the recessed area, the synthetic quartz glass lid obtained as described above was set on the housing member so as to cover the recessed area in which the UV-LED has been placed, and the window material and the housing member were bonded by applying heat and pressure for 15 minutes under conditions of 180°C and 400 gf/package (3.92 N/package), thereby giving an optical element package. The hermeticity of the resulting optical element package was evaluated in the same way as in Example 1.

In the red dye check before the evaluation of resistance to ultraviolet light, infiltration of the penetrating fluid into the optical element package was not observed and the maintenance of sufficient hermeticity was confirmed. Also, the helium leak rate in the fine leak test was 5.0×10⁻⁹ Pa·m³/s, indicating sufficient hermeticity. However, in the red dye check after the evaluation of resistance to ultraviolet light, infiltration of the penetrating fluid into the optical element package was observed. Also, under examination of the bonding joint by microscope, cracks that had arisen due to damage by ultraviolet light were observed in areas where the adhesion layer made of epoxy adhesive was cured, and partial separation of the window material and housing member had occurred.

### REFERENCE SIGNS LIST

- 1: Window material
- 2: Metallic adhesion layer
- 3: Housing member
- 4: Optical element
- 5: Reflector

## Claims

1. A lid for an optical element package, comprising a window material provided in front of a housing member in a direction of light emission by an optical element housed inside the housing member, and a metallic adhesion layer formed on a portion of the window material that adjoins the housing member, wherein the metallic adhesion layer is formed of an adhesive composition comprising metal nanoparticles coated with a coating agent, solder powder and dispersion medium.

2. An optical element package lid of claim 1, wherein the metal making up the metal nanoparticles is one or more metals selected from the group consisting of gold, silver and copper, alloys containing such metal, and mixtures of such metals with another metal.

3. An optical element package lid of claim 1 or 2, wherein the metal nanoparticles have an average primary particle size, as determined by dynamic light scattering, of from 20 to 90 nm.

4. An optical element package lid of any one of claims 1 to 3, wherein the coating agent has a temperature of separation from the metal nanoparticles which is at or above a sintering temperature of the metal nanoparticles.

5. An optical element package lid of claim 4 wherein the coating agent comprises one or more compounds selected from the group consisting of amines, aliphatic carboxylic acids and alcohols.

6. An optical element package lid of claim 4 wherein the coating agent comprises polyethylene glycol.

7. An optical element package lid of any one of claims 1 to 6 wherein the metal nanoparticles have a sintering temperature of between 110°C and 180°C.

8. An optical element package lid of any one of claims 1 to 7 wherein the solder powder has a melting point which is lower than the sintering temperature of the metal nanoparticles.

9. An optical element package lid of claim 8 wherein the solder powder comprises at least one selected from the group consisting of Sn-Bi solder, Sn-Zn-Bi solder and Sn-Zn solder.

10. An optical element package lid of any one of claims 1 to 9 wherein the dispersion medium has a volatilization onset temperature which is higher than the sintering temperature of the metal nanoparticles and higher than a melting point of the solder powder.

11. An optical element package lid of claim 10 wherein the dispersion medium comprises one or more compounds selected from the group consisting of terpenes, monoterpene alcohols, alkyl alcohols and naphthenic hydrocarbons.

12. An optical element package lid of any one of claims 1 to 11 wherein the metallic adhesion layer is in a semi-cured state (B-Stage).

13. A method for manufacturing an optical element package lid of any one of claims 1 to 12, comprising the step of:
forming the metallic adhesion layer by applying the adhesive composition onto a portion of the window material that adjoins the housing member.

14. An optical element package comprising an optical element and a housing member that houses therein the optical element, wherein the metallic adhesion layer of an optical element package lid of any one of claims 1 to 12 bonds together the window material and the housing member, hermetically sealing the optical element inside the housing member.

15. An optical element package of claim 14 wherein the optical element is a light-emitting element or a light-receiving element.

16. An optical element package of claim 15, wherein the optical element is an optical element capable of emitting or receiving light at a wavelength of 300 nm or less.

17. A method for manufacturing an optical element package of any one of claims 14 to 16, comprising the steps of:
mounting an optical device inside a housing member, and
bonding and integrally uniting, by means of the metallic adhesion layer of the optical element package lid, the window material of the optical element package lid of any one of claims 1 to 12 with the housing member that houses therein the optical device.
